# EUROPEAN PATENT APPLICATION

(11) **EP 4 231 362 A1**
(43) Date of publication of application: **23.08.2023**
(21) Application number: 22157829.7
(22) Date of filing: 21.02.2022
(51) Int. Cl.: H01L 31/0216, H01L 31/0687, H01L 31/0304, H01L 31/18, B64G 1/44

(54) **MULTIJUNCTION SOLAR CELL**

(71) Applicant: SolAero Technologies Corp., a corporation of the state of Delaware, Albuquerque, NM 87123 (US)
(72) Inventor: DERKACS, Daniel, Albuquerque, 87111 (US); ESPENLAUB, Andrew Colin, Albuquerque, 87111 (US)
(74) Representative: de Rooij, Mathieu Julien

(57) **Abstract**

A multijunction solar cell including a substrate and a top (or light-facing) solar subcell having an emitter layer, a base layer, and a window layer adjacent to the emitter layer, the window layer composed of a material is specified such that the material is optically transparent, has a band gap of greater than 2.6 eV, and includes an appropriately arranged multilayer antireflection coating so as to increase the short circuit current in the top solar subcell.

## Description

### BACKGROUND

### 1. Field of the Invention

The present disclosure relates to solar cells and the fabrication of solar cells, and more particularly the design and specification of the window layer in the top solar subcell, and the antireflective coating layer, in multijunction solar cells based on III-V semiconductor compounds.

### 2. Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. Under high solar concentration (e.g., 500X), commercially available III-V compound semiconductor multijunction solar cells in terrestrial applications (at AM1.5D) have energy efficiencies that exceed 37%. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided by the photovoltaic power system. Thus, as payloads become more sophisticated, weight or mass of the photovoltaic power system, and more particularly the power-to-weight ratio of the solar cells becomes increasingly more important, and there is increasing interest in lighter weight, "thin film" type solar cells having both high efficiency and low mass.

The efficiency of energy conversion, which converts solar energy (or photons) to electrical energy, depends on various factors such as the design of solar cell structures, the choice of semiconductor materials, and the thickness of each cell. In short, the energy conversion efficiency for each solar cell is dependent on the optimum utilization of the available sunlight across the solar spectrum by the subcells in a multijunction solar cell. As such, the characteristic of sunlight absorption in semiconductor material, also known as photovoltaic properties, is critical to determine the most efficient number and sequence of subcells, and the semiconductor material (with specific bandgap, thickness, and electrical properties) in each subcell, to achieve the optimum energy conversion.

Typical III-V compound semiconductor solar cells are fabricated on a semiconductor wafer in vertical, multijunction structures or stacked sequence of solar subcells, each subcell formed with appropriate semiconductor layers and including a p-n photoactive junction. Each subcell is designed to convert photons over different spectral or wavelength bands to electrical current. After the sunlight impinges on the front of the solar cell, and photons pass through the subcells, the photons in a wavelength band that are not absorbed and converted to electrical energy in the region of one subcell propagate to the next subcell, where such photons are intended to be captured and converted to electrical energy, assuming the downstream subcell is designed for the photon's particular wavelength or energy band.

The individual solar cells or wafers are then disposed in horizontal arrays, with the individual solar cells connected together in an electrical series and/or parallel circuit. The shape and structure of an array, as well as the number of cells it contains, are determined in part by the desired output voltage and current needed by the payload or subcomponents of the payload.

The energy conversion efficiency of multijunction solar cells is affected by such factors as the number of subcells, the thickness of each subcell, and the band structure, electron energy levels, conduction, and absorption of each subcell. Factors such as the short circuit current density (J_{sc}), the open circuit voltage (V_{oc}), and the fill factor are also important characterizing parameters in describing a subcell.

One of the important mechanical or structural considerations in the choice of semiconductor layers for a solar cell is the desirability of the adjacent layers of semiconductor materials in the solar cell, i.e. each layer of crystalline semiconductor material that is deposited and grown to form a solar subcell, have similar crystal lattice constants or parameters.

Many III-V devices, including solar cells, are fabricated by thin epitaxial growth of III-V compound semiconductors upon a relatively thick substrate. The substrate, typically of Ge, GaAs, InP, or other bulk material, acts as a template for the formation of the deposited epitaxial layers. The atomic spacing or lattice constant in the epitaxial layers will generally conform to that of the substrate, so the choice of epitaxial materials will be limited to those having a lattice constant similar to that of the substrate material.

The window layer is a semiconductor layer typically having a thickness of between 200 and 300 Angstroms (or 20 to 30 nm) that is disposed between the surface layer of the solar cell (which may be the antireflection coating or ARC layer, or the contact layer on which is deposited metallic grid lines over the top surface of the contact layer) and the emitter layer of the top subcell, or between the tunnel diode and the emitter layer of a lower subcell. The window layer is introduced in the vertical stack of semiconductor layers to improve subcell efficiency by preventing minority carrier recombination at the top surface of the emitter layer, thereby permitting the minority carriers present in the emitter to migrate to the p-n junction of the subcell, thereby contributing to the extracted electrical current. By being identified as a distinct layer, the window layer will have a composition that differs from both the adjacent layer and the emitter layer, but will generally be lattice matched to both semiconductor layers.

In some embodiments, the window layer may have a higher band gap than the adjacent emitter layer, with the higher band gap tending to suppress minority-carrier injection into the window layer, and as a result tending to reduce the recombination of electron-hole pairs that would otherwise occur in the window layer, thereby decreasing the efficiency of photon conversion at that subcell, and thus the overall efficiency of the solar cell.

Since the window layer can be directly adjacent to the emitter layer, the interface with the emitter layer is appropriately designed so as to minimize the number of minority carriers entering the window. Another characteristic is the deep energy levels in the band gap, and here again one wishes to minimize such deep energy levels which would tend to create sites that could participate in Shockley-Read-Hall (SRH) recombination of electron-hole pairs. Since crystal defects can cause these deep energy levels, the composition and morphology of the window layer should be capable of forming an interface with the emitter layer that would minimize the crystal defects at the interface.

The oxidation of a window layer for the purpose of enhancing the efficiency of a solar cell is very generically known from U.S. Patent No. 9,356,162 of Pan et al. However, the specific type of window layer and the process taught therein are quite restricted and limited, and the resulting quantum efficiency associated with such prior art is highly unsatisfactory from a commercial perspective.

In order to substantially improve the efficiency of a solar cell even further, the present disclosure proposes additional design features for the material and the fabrication of window layer that have heretofore not been considered or proposed.

### SUMMARY

### Objects of the Disclosure

It is an object of the present disclosure to provide increased photoconversion efficiency in a multijunction solar cell by optimally adjusting the composition of the window layer above the top (or light-facing) solar subcell.

It is another object of the present disclosure to provide increased photoelectric efficiency in a multijunction solar cell by providing a window layer of the top solar subcell composed of zinc selenide.

It is another object of the present disclosure to provide improved photoelectric efficiency in a multijunction solar cell by oxidizing a portion of the thickness of an InAIP window layer in the top solar subcell from the emitter/window layer contact surface to the top surface of the window layer while the solar cell is in the growth reactor.

It is another object of the present disclosure to provide a method of fabricating a multijunction solar cell including dry or wet oxidation or optionally a chemical oxidation process of the window layer of the top solar subcell.

It is another object of the present disclosure to provide increased photoelectric efficiency in a multijunction solar cell by providing a passivation layer below the window layer and above the emitter layer of the top solar subcell.

It is another object of the present disclosure to provide improved photoelectric efficiency in a multijunction solar cell by oxidizing a portion of the thickness of an InAIP window layer in the top solar subcell from the emitter/window layer contact surface to an oxidation stop layer disposed over the top surface of the emitter layer of the top solar subcell.

Throughout the present disclose, an "oxidation stop layer" may be regarded as a layer configured to stop or limit an oxidation process.

It is another object of the present disclosure to provide a method of fabricating a multijunction solar cell by dry oxidation, wet oxidation or chemical oxidation of the window layer of the top solar subcell down to an oxidation stop layer disposed directly over the emitter of the top solar subcell.

It is another object of the present disclosure to provide increased photoconversion efficiency in a multijunction solar cell by optimally adjusting the composition of the antireflective coating layer which is above the window layer of the top solar subcell.

It is another object of the present disclosure to provide increased photoconversion efficiency in an upright metamorphic multijunction solar cell or in an inverted metamorphic multijunction solar cell by fabrication of a window layer with a band gap greater than 2.6 eV, or optionally greater than 4 eV, disposed above the top solar subcell prior to the deposit and etching of a cap layer over the window layer.

Some implementations of the present disclosure may incorporate or implement fewer of the aspects and features noted in the foregoing objects.

### 2. Features of the Disclosure

All ranges of numerical parameters set forth in this disclosure are to be understood to encompass any and all subranges or "intermediate generalizations" subsumed herein. For example, a stated range of "1.0 to 2.0 eV" for a band gap value should be considered to include any and all subranges beginning with a minimum value of 1.0 eV or more and ending with a maximum value of 2.0 eV or less, e.g., 1.1 to 2.0, or 1.3 to 1.4, or 1.5 to 1.9 eV.

Briefly, and in general terms, the present disclosure provides a multijunction solar cell comprising a top (or light-facing) solar subcell having an emitter layer and a base layer forming a photovoltaic junction, and a window layer disposed over and adjacent to the emitter layer composed of a window material having a band gap of greater than 2.6 eV and a thickness of less than 100 nm.

Throughout the present disclosure the "top" solar subcell may be regarded as the subcell that is at or near the light receiving side of the solar cell. The "bottom" solar subcell is arranged at or near an opposite side of the solar cell.

In some embodiments, the emitter of the top solar subcell is composed of InAIGaP with the aluminum content in the range of 10 to 40% by mole fraction.

In some embodiments, the window layer is composed of an oxidized material.

In some embodiments, the window layer is composed of AIGaAs that is oxidized.

In some embodiments, an oxidation stop layer is disposed below the window layer, above the emitter layer.

In some embodiments, the window layer is composed of InAIP with an AI content approximately 65% by mole fraction and a thickness between 10 and 40 nm.

In some embodiments, the window layer is composed of AIGaAs with an Al content in the range of 40 to 80% by mole fraction and a thickness between 10 and 40 nm.

In some embodiments, in which the window layer is composed of InAIP, the oxidation stop layer is composed of InAIP with an Al content of 50% by mole fraction and a thickness of between 5 and 10 nm.

In some embodiments, in which the window layer is composed of AIGaAs, the oxidation stop layer is composed of InAIP with an Al content in the range of 50 to 65% by mole fraction and a thickness between 5 and 10 nm.

In some embodiments, the window layer is composed of zinc selenide with a band gap greater than 2.6 eV.

In some embodiments, a cap layer is disposed over the window layer, with portions of the cap layer being subsequently etched down to the surface of the window layer.

In some embodiments, portions of the window layer being exposed following etching of portions of the cap layer are subjected to an oxidation process.

In some embodiments, the oxidation process takes place in a separate apparatus following epitaxial deposition of the wafer in a MOCVD reactor, and is a wet oxidation, a dry oxidation, or a chemical oxidation process.

In some embodiments, the multijunction solar cell is fabricated in an MOCVD reactor, and the window layer material is oxidized in the reactor. In some embodiments, the oxidation process in the MOCVD reactor is a dry oxidation process.

In some embodiments, at least 10 nm of the top surface of the window layer is oxidized.

In some embodiments, the window layer is composed of InAIP or InGaP and the AI content at the bottom surface of the window layer is 48.5% or less.

In some embodiments, the solar cell is a three junction solar cell with the window layer being a doped semiconductor layer, and wherein the top solar subcell has over 1 mA/cm² of current absorbed by the top solar subcell.

In some embodiments, the base of the top solar subcell is composed of InGaP and the emitter of the top solar subcell is composed of InGaP, and the base of the top solar subcell has a band gap that is equal to or greater than 1.87 eV.

In some embodiments, the emitter of the top solar subcell has a thickness of 80 nm, and the window layer disposed above the top solar subcell has a thickness of less than 220 Angstroms.

In some embodiments, the multijunctional solar cell further comprises a second solar subcell disposed below the top solar subcell and a lower solar subcell; wherein the top solar subcell is composed of at least indium, gallium and phosphorus; wherein the second solar subcell is disposed adjacent to and lattice matched to said upper first solar subcell, the second solar subcell including an emitter layer composed of indium, gallium, phosphide or aluminum, indium, gallium arsenide, and a base layer composed of at least indium, gallium, and arsenic that is lattice matched to the emitter layer.

In some embodiments, the top solar subcell is composed of indium gallium aluminum phosphide and having a first band gap in the range of 2.0 to 2.2 eV; and further comprising: (i) a second solar subcell adjacent to said top solar subcell and including an emitter layer composed of indium gallium phosphide or aluminum indium gallium arsenide, and a base layer composed of aluminum indium gallium arsenide and having a second band gap in the range of approximately 1.55 to 1.8 eV and being lattice matched with the upper first solar subcell, wherein the emitter and base layers of the second solar subcell form a photoelectric junction; (ii) a third solar subcell adjacent to said second solar subcell and composed of indium gallium arsenide and having a third band gap less than that of the second solar subcell and being lattice matched with the second solar subcell; and (iii) a fourth solar subcell adjacent to said third solar subcell and composed of germanium and having a fourth band gap of approximately 0.67 eV; wherein the average band gap of all four subcells is equal to or greater than 1.35 eV, the average band gap of the solar cell being the numerical average of the lowest band gap material used in each subcell.

In another aspect, the present disclosure provides a multijunction solar cell comprising: a top solar subcell having an emitter layer, a base layer, and a window layer composed of zinc selenide and disposed adjacent to the emitter layer, the window having a band gap of greater than 2.6 eV, specifically greater than 4 eV, and a thickness less than 30 nm.

In another aspect the present disclosure provides a method of manufacturing a multijunction solar cell comprising: growing an epitaxial sequence of solar subcells with different band gaps on a substrate including a top solar subcell of the sequence of solar subcells having an emitter layer and a base layer; and depositing a window layer having a band gap of 2.6 eV or greater, specifically 4 eV or greater, over the emitter layer of the top solar subcell to a thickness of less than 30 nm.

In another aspect the present disclosure provides a method of manufacturing a solar cell comprising: (i) growing an epitaxial sequence of solar subcells with different band gaps on a substrate including a top (or light-facing) solar subcell of the sequence of solar subcells having an emitter layer and a base layer forming a photovoltaic junction; (ii) epitaxially growing a window layer over the emitter layer of the top solar subcell to a thickness of less than 100 nm; and (iii) oxidizing the surface of the window layer.

In another aspect the present disclosure provides a method of manufacturing a solar cell comprising: (i) growing an epitaxial sequence of solar subcells with different band gaps on a substrate, including a top (or light-facing) solar subcell of the sequence of solar subcells having an emitter layer and a base layer forming a photovoltaic junction; (ii) depositing an oxidation stop layer over the emitter layer of the top solar subcell to a thickness of between 5 and 10 nm; (iii) depositing a window layer over the oxidation stop layer of the top solar subcell to a thickness of between 10 and 40 nm; and (iv) oxidizing the entire window layer.

In another aspect, the present disclosure provides a method of fabricating a multijunction solar cell comprising: (i) forming a top (or light-facing) solar subcell having an emitter layer and a base layer forming a photovoltaic junction, and a window layer adjacent to the emitter layer; (ii) depositing window layer being composed of a window material having a band gap of greater than 4 eV and a thickness of less than 25 nm; (iii) growing a cap layer over the window layer; and (iv) etching portions of the cap layer down to the surface of the window layer.

In some embodiments, portions of the window layer that is exposed following etching of portions of the cap layer are subjected to an oxidation process.

In some embodiments, the solar cell may further comprise an antireflection structure deposited on the windows layer, and having a sequence of layers with a lower band gap than the band gap of the window layer, followed by a directly adjacent layer with a higher band gap than the band gap of the window layer, deposited over the cap layer of the solar cell

In another aspect the present disclosure provides a method of manufacturing a solar cell comprising: (i) forming a sequence of solar subcells with different band gaps on a substrate, the top (or light-facing) solar subcell of the sequence of solar subcells having an emitter layer and a base layer forming a photovoltaic junction; (ii) depositing a window layer over the emitter layer of the top solar subcell, the window layer including a first sublayer with a thickness in the range of 5 to 10 nm and an Al content of 50 to 65% by mole fraction, and a second sublayer deposited over the first layer with a thickness in the range of 25 to 100 nm and an Al content of less than 50% by mole fraction; and (iii) oxidizing the second sublayer of the window layer.

In another aspect the present disclosure provides a method of manufacturing a solar cell comprising: (i) forming a sequence of solar subcells with different band gaps on a substrate, the top (or light-facing) solar subcell of the sequence of solar subcells having an emitter layer and a base layer; (ii) depositing a window layer over the emitter layer of the top solar subcell to a thickness of less than 30 nm; and (iii) oxidizing the surface of the window layer, and particularly oxidizing the entire surface of the window layer using a dry or wet oxidation process, or optionally a chemical oxidation process.

In another aspect the present disclosure provides a method of manufacturing a solar cell comprising: (i) forming a tandem sequence of solar subcells with different band gaps on a substrate, including a top (or light-facing) solar subcell, the top solar subcell having an emitter layer and a base layer forming a photovoltaic junction; (ii) depositing a passivation layer over the emitter layer of the top solar subcell; (iii) depositing a window layer over the passivation layer; (iv) depositing a cap layer over the window layer; (v) depositing a metal grid layer over portions of the cap layer; and (vi) etching portions of the cap layer down to the passivation layer.

In another aspect the present disclosure provides a method of manufacturing a solar cell comprising: forming a tandem sequence of solar subcells with different band gaps on a substrate; including a top (or light-facing) solar subcell, the top solar subcell having an emitter layer and a base layer forming a photovoltaic junction; depositing a window layer over the emitter layer of the top solar subcell to a thickness of less than 30 nm; depositing a cap layer over portions of the window layer; and oxidizing the exposed top surface of the window layer.

In some embodiments, the window material located at the interface between the top surface of the emitter layer of the solar subcell and the bottom of the window is in compression with the emitter, and the material at the top surface of the window layer is in tension.

More particularly, the present disclosure is concerned with the processing of the top window layer in a solar cell with a specific composition which results in a corresponding change in the photon absorption in the material throughout the thickness of the window layer allowing greater current to be generated in the top subcell.

Another way of describing the window material of the top solar subcell of the present disclosure for an embodiment in which the window layer is composed of InAIP or InGaP, is to define the amount of aluminum in mole fraction throughout the thickness of the window layer.

In some embodiments, the window layer is composed of InAIP or InGaP and the Al content at the bottom surface of the window layer is 48.9% or less.

In the same or other embodiments, the window layer is composed of InAIP or InGaP and the Al content at the top surface of the window layer is 53.6% or more.

In some embodiments, the window layer is composed of InAIP or InGaP and the gradation in Al content in the window layer from the bottom surface to the top surface of the window layer is an increase of at least 5%.

In some embodiments, the window layer is composed of InAIP or InGaP and the Al content in the window layer increases from the bottom surface of the window layer to the top surface of the window layer.

In another aspect, the present disclosure provides a method of fabricating a solar cell including forming a sequence of solar subcells with different band gaps on a substrate; the top solar subcell of the sequence of solar subcells having an emitter layer and a base layer forming a photovoltaic junction, depositing a layer of zinc selenide over the emitter layer.

In some embodiments, the emitter of the top solar subcell has a thickness of 80 nm, and the window layer has a thickness of less than 220 Angstroms.

In some embodiments, the base of the top solar subcell has a thickness of less than 700 nm.

In some embodiments, the base of the top solar subcell has a thickness of 670 nm.

In some embodiments, the top solar subcell is composed of an InGaP emitter layer and an InGaP base layer, the second subcell is composed of GalnP emitter layer and a GaAs base layer, and further comprising at least a third subcell composed of a Ge emitter layer and a Ge base layer.

In some embodiments, the third solar subcell has a band gap of 0.67 eV, the second solar subcell has a band gap in the range of approximately 1.35 to 1.50 eV and the top solar subcell has a band gap in the range of 1.87 to 2.2 eV.
In some embodiments, the multijunction solar cell comprises a second solar subcell disposed below the top solar subcell and a bottom solar subcell disposed below the second solar subcell, wherein (i) the top subcell is composed of indium gallium phosphide; (ii) the second solar subcell is disposed adjacent to and lattice matched to said top solar subcell, the second solar subcell including an emitter layer composed of indium gallium phosphide, and a base layer composed of indium gallium arsenide that is lattice matched to the emitter layer; and (iii) the bottom solar subcell is lattice matched to said second solar subcell and is composed of germanium.

In some embodiments, the multijunction solar cell is a four junction solar cell with: (i) the top solar subcell being composed of indium gallium aluminum phosphide and having a band gap in the range of 2.0 to 2.2 eV; (ii) a second solar subcell adjacent to said top solar subcell and including an emitter layer composed of indium gallium phosphide or aluminum indium gallium arsenide, and a base layer composed of aluminum indium gallium arsenide and having a second band gap in the range of approximately 1.55 to 1.8 eV and being lattice matched with the upper first solar subcell, wherein the emitter and base layers of the second solar subcell form a photoelectric junction; (iii) a third solar subcell adjacent to said second solar subcell and composed of indium gallium arsenide and having a band gap less than that of the second solar subcell and being lattice matched with the second solar subcell; and (iv) a fourth solar subcell adjacent to said third solar subcell and composed of germanium and having a band gap of 0.67 eV.

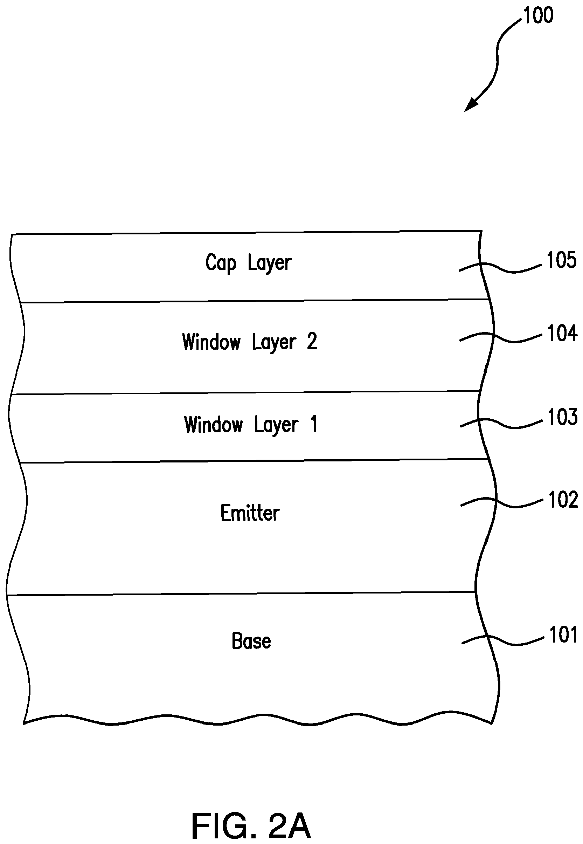

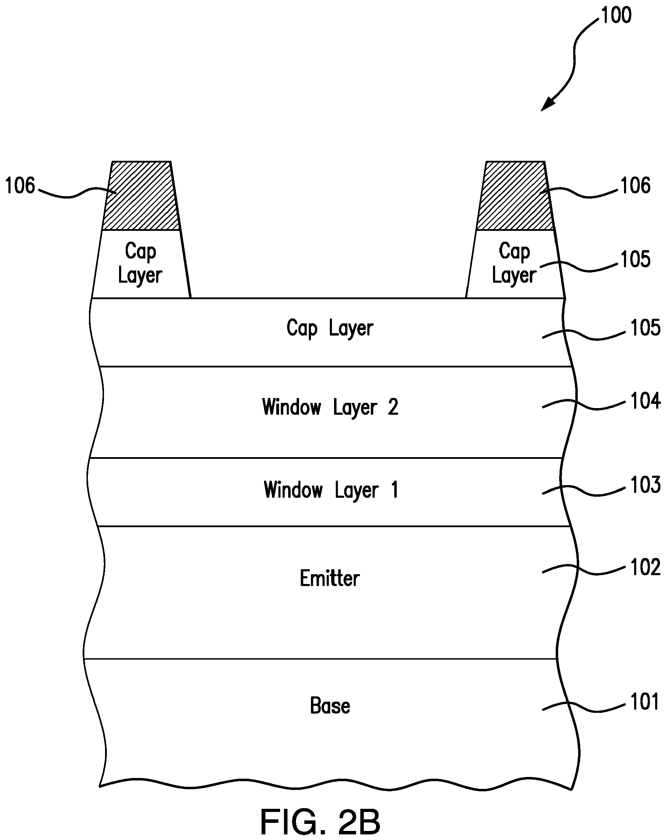

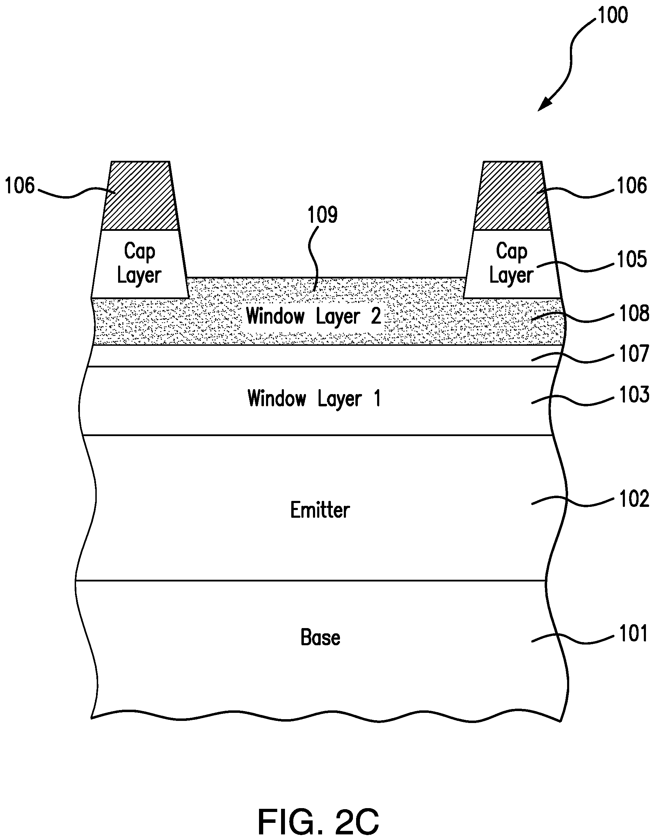

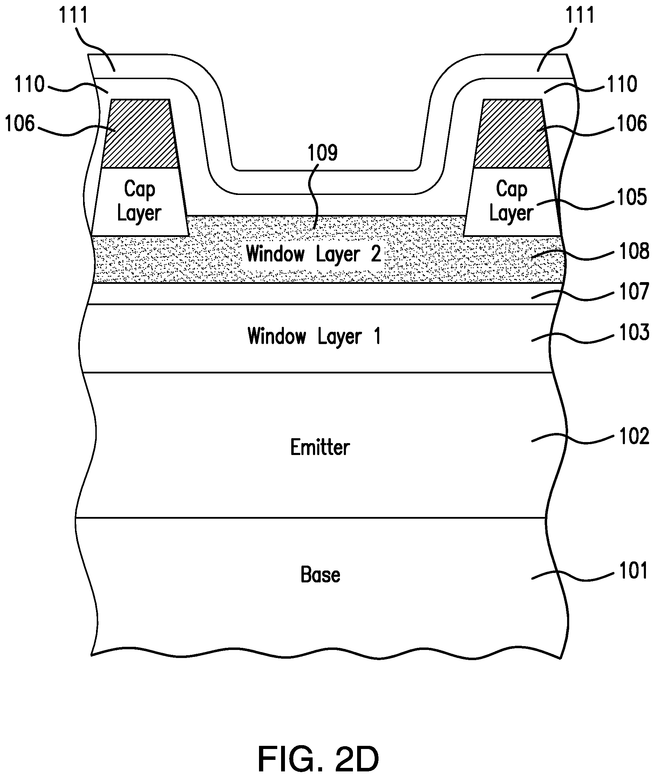

In some embodiments of the four junction solar cell, the average band gap of all four subcells is equal to or greater than 1.35 eV, the average band gap of the solar cell being the numerical average of the lowest band gap material used in each subcell. U.S. Patent Application Serial No. 17/180,210 filed February 19, 2021 illustrates and describes a number of such four junction solar cells embodiments in FIGs. 2, 3 and 4 thereof, and is hereby incorporated by reference in its entirety.

In another aspect, the present disclosure provides a method of manufacturing a solar cell comprising: forming an upper first solar subcell having a first band gap; forming a second solar subcell adjacent to said first solar subcell and having a second band gap smaller than said first band gap; forming a third solar subcell adjacent to said second solar subcell and having a third band gap smaller than said second band gap; and forming a window layer over the top solar subcell, the window layer being less than 30 nm in thickness, and being formed by wet or dry oxidation of the material in the window layer.

In some embodiments, the base of the top solar subcell has a thickness of less than 400 nm.

In some embodiments, the base of the upper first solar subcell has a thickness of 260 nm.

In some embodiments, additional layer(s) may be added or deleted in the cell structure without departing from the scope of the present disclosure.

Some implementations of the present disclosure may incorporate or implement fewer of the aspects and features noted in the foregoing summaries.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the disclosure as disclosed and claimed herein and with respect to which the disclosure could be of utility.

### BRIEF DESCRIPTION OF THE DRAWINGS

The invention will be better and more fully appreciated by reference to the following detailed description when considered in conjunction with the accompanying drawings, wherein:
FIG. 1 is a cross-sectional view of the top solar cell of a multijunction solar cell after several stages of fabrication including the deposition of certain semiconductor layers on the growth substrate up to the grid lines;
FIG. 2A is a highly simplified cross sectional view of the semiconductor layers structure including the window layer directly above the top solar subcell according to the present disclosure;
FIG. 2B is a highly simplified cross sectional view of the structure of FIG. 2A after the next process step in which the cap layer is etched according to the present disclosure;
FIG. 2C is a highly simplified cross sectional view of the structure of FIG. 2B after oxidation according to the present disclosure;
FIG. 2D is a highly simplified cross sectional view of the structure of FIG. 2C after deposition of the ARC layers according to the present disclosure;
FIG. 3 is a first embodiment of a space vehicle incorporating a photoelectric power system according to the present disclosure; and
FIG. 4 is a second embodiment of a space vehicle incorporating a photoelectric power system with roll-out deployment according to the present disclosure.

### DETAILED DESCRIPTION OF EMBODIMENTS

Details of the present disclosure will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

The present disclosure provides a process for the design and fabrication of a window layer in a multijunction solar cell that improves light capture in the associated top subcell and thereby the overall efficiency of the solar cell. More specifically, the present disclosure intends to provide a relatively simple and reproducible technique that is suitable for use in a high volume production environment in which various semiconductor layers are deposited in an MOCVD reactor, and subsequent processing steps are defined and selected to minimize any physical damage to the quality of the deposited layers, thereby ensuring a relatively high yield of operable solar cells meeting specifications at the conclusion of the fabrication processes.

Another aspect of the present disclosure is the design of the antireflective coating layer (ARC) disposed over the window layer. An antireflective coating is typically formed by a stack of several thin-film interference layers with alternating lower and higher refractive index layers (e.g., a first set of silicon dioxide layers interleaved with a second set of silicon nitride layers). The lower refractive index layers may form upper-most and lower-most layers of the coating. As examples, the coating may be a seven-layer coating having four lower refractive index layers and three higher refractive index layers or five-layer coating having the lower refractive index layers and two higher refractive index layers. The layers may have thickness and materials that configure the coating to exhibit a photopic reflectance of less than 1.5% and transmittance of greater than 4% within range of wavelengths associated with the incoming light received by the solar subcells. With the implementation of a new window layer with high band gap according to the present disclosure, it is important that a suitable ARC be designed to match the characteristics of the new window layer, as will be subsequently described.

Prior to discussing the specific embodiments of the present disclosure, a brief discussion of some of the issues associated with the design of multijunction solar cells, and the context of the composition or deposition of various specific layers and in particular the top window layer in embodiments of the product as specified and defined by Applicant is in order.

There are a multitude of properties that should be considered in specifying and selecting the composition of, inter alia, a specific semiconductor layer, the back metal layer, the adhesive or bonding material, or the composition of the supporting material for mounting a solar cell thereon. For example, some of the properties that should be considered when selecting a particular layer or material are electrical properties (e.g. conductivity), optical properties (e.g., band gap, absorbance and reflectance), structural properties (e.g., thickness, strength, flexibility, Young's modulus, etc.), chemical properties (e.g., growth rates, the "sticking coefficient" or ability of one layer to adhere to another, stability of dopants and constituent materials with respect to adjacent layers and subsequent processes, etc.), thermal properties (e.g., thermal stability under temperature changes, coefficient of thermal expansion), and manufacturability (e.g., availability of materials, process complexity, process variability and tolerances, reproducibility of results over high volume, reliability and quality control issues).

In view of the trade-offs among these properties, it is not always evident that the selection of a material based on one of its characteristic properties is always or typically "the best" or "optimum" from a commercial standpoint or for Applicant's purposes. For example, theoretical studies may suggest the use of a quaternary material with a certain band gap for a particular subcell would be the optimum choice for that subcell layer based on fundamental semiconductor physics. As an example, the teachings of academic papers and related proposals for the design of very high efficiency (over 40%) solar cells may therefore suggest that a solar cell designer specify the use of a quaternary material (e.g., InGaAsP) for the active layer of a subcell. A few such devices may actually be fabricated by other researchers, efficiency measurements made, and the results published as an example of the ability of such researchers to advance the progress of science by increasing the demonstrated efficiency of a compound semiconductor multijunction solar cell. Although such experiments and publications are of "academic" interest, from the practical perspective of the Applicants in designing a compound semiconductor multijunction solar cell to be produced in high volume at reasonable cost and subject to manufacturing tolerances and variability inherent in the production processes, such an "optimum" design from an academic perspective is not necessarily the most desirable design in practice, and the teachings of such studies more likely than not point in the wrong direction and lead away from the proper design direction. Stated another way, such references may actually "teach away" from Applicant's research efforts and the ultimate solar cell design proposed by the Applicants.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

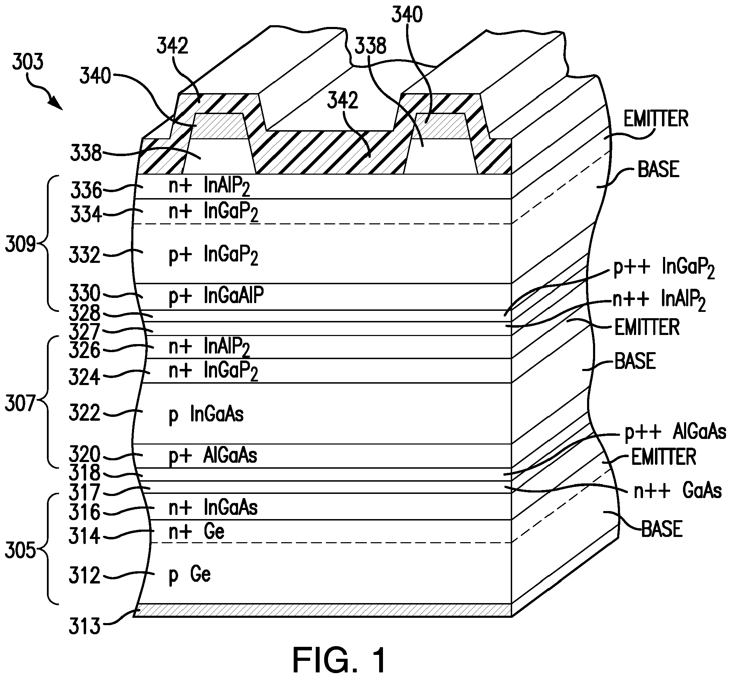

FIG. 1 illustrates one example of a multijunction solar cell device 303 which may be used to implement the window layer as provided by the present disclosure. In the Figure, each dashed line indicates the active region junction between a base layer and emitter layer of a subcell.

As shown in the illustrated example of FIG. 1, the bottom subcell 305 includes a substrate 312 formed of p-type germanium ("Ge") which also serves as a base layer. A contact pad 313 formed on the bottom of base layer 312 provides electrical contact to the multijunction solar cell 303. The bottom subcell 305 further includes, for example, a highly doped n-type Ge emitter layer 314, and an n-type indium gallium arsenide ("InGaAs") nucleation layer 316. The nucleation layer is deposited over the base layer 312, and the emitter layer is formed in the substrate by diffusion of deposits into the Ge substrate, thereby forming the n-type Ge layer 314. Heavily doped p-type aluminum gallium arsenide ("AIGaAs") and heavily doped n-type gallium arsenide ("GaAs") tunneling junction layers 318, 317 may be deposited over the nucleation layer 316 to provide a low resistance pathway between the bottom and middle subcells.

In the illustrated example of FIG. 1, the middle subcell 307 includes a highly doped p-type aluminum gallium arsenide ("AIGaAs") back surface field ("BSF") layer 320, a p-type InGaAs base layer 322, a highly doped n-type indium gallium phosphide ("InGaP2") emitter layer 324 and a highly doped n-type indium aluminum phosphide ("AlInP2") window layer 326. The InGaAs base layer 322 of the middle subcell 307 can include, for example, approximately 1.5% In. Other compositions may be used as well. The base layer 322 is formed over the BSF layer 320 after the BSF layer is deposited over the tunneling junction layers 318 of the bottom subcell 304.

The BSF layer 320 is provided to reduce the recombination loss in the middle subcell 307. The BSF layer 320 keeps minority carriers away from a highly doped region near the back surface to minimize the effect of recombination loss. Thus, the BSF layer 320 reduces recombination loss at the backside of the solar cell and thereby reduces recombination at the base layer/BSF layer interface. The window layer 326 is deposited on the emitter layer 324 of the middle subcell B. The window layer 326 in the middle subcell B also helps reduce the recombination loss and improves passivation of the cell surface of the underlying junctions. Before depositing the layers of the top cell C, heavily doped n-type InGaP and p-type AIGaAs tunneling junction layers 327, 328 may be deposited over the middle subcell B.

In the illustrated example, the top subcell 309 includes a highly doped p-type indium gallium aluminum phosphide ("InGaAIP") BSF layer 330, a p-type InGaP2 base layer 332, a highly doped n-type InGaP2 emitter layer 334 and a highly doped n-type InAIP2 window layer 336. The base layer 332 of the top subcell 309 is deposited over the BSF layer 330 after the BSF layer 330 is formed over the tunneling junction layers 328 of the middle subcell 307. The window layer 336 is deposited over the emitter layer 334 of the top subcell after the emitter layer 334 is formed over the base layer 332. Details of the window layer as taught by the present disclosure will be discussed in connection with FIG. 2A.

A cap or contact layer 338 may be deposited and patterned into separate contact regions over the window layer 336 of the top subcell 308. The cap or contact layer 338 serves as an electrical contact from the top subcell 309 to metal grid layer 340. The doped cap or contact layer 338 can be a semiconductor layer such as, for example, a GaAs or InGaAs layer.

After the cap or contact layer 338 is deposited, the grid lines 340 are formed. The grid lines 340 are deposited via evaporation and lithographically patterned and deposited over the cap or contact layer 338. The mask is subsequently lifted off to form the finished metal grid lines 340 as depicted in Figure 1, and the portion of the cap layer that has not been metallized is removed, exposing the surface of the window layer 336. In some embodiments, a trench or channel (not shown), or portion of the semiconductor structure, is also etched around each of the solar cells. These channels define a peripheral boundary between the solar cell (later to be scribed from the wafer) and the rest of the wafer, and leaves a mesa structure (or a plurality of mesas, in the case of more than one solar cell per wafer) which define and constitute the solar cells later to be scribed and diced from the wafer.

As more fully described in U.S. Patent Application Serial No. 12/218,582 filed July 16, 2008, hereby incorporated by reference, the grid lines 340 are preferably composed of Ti/Au/Ag/Au, although other suitable materials may be used as well.

FIG. 2A is a highly simplified cross sectional view of the semiconductor layer structure including the window layer disposed directly above the top solar subcell of a multijunction solar cell according to the present disclosure.

The emitter 102 and base 101 of the top solar subcell are illustrated which would correspond to layers 334 and 332 in FIG. 1 On top of the emitter 102 a first window sublayer 103 is grown which will function as an oxidation stop layer as well as preventing minority carrier recombination at the top surface of the emitter layer. In some embodiments, such layer is from 5 to 10 nm in thickness and is lattice matched with the emitter layer.

A second window sublayer 104 is grown on top of first window sublayer 103 and has a substantially greater thickness than first window sublayer 103, such as in the range of 25 to 80 nm. The second window sublayer has a different composition than that of the first window sublayer 103 and in some embodiments has an Al content of from 65 to 80% by mole fraction.

A cap layer 105 is then grown over the second window sublayer 104.

From a processing perspective, the thickness of the second window sublayer is designed so that in some embodiments, upon completion of the oxidation process only a portion of the thickness of the second window layer is oxidized, that is less than the entire thickness of the second window layers. Such process operation may be controlled by adjusting the time and temperature of the oxidation process or other parameter so as to move precisely and consistently define the oxidized thickness.

In some embodiments, more than two sublayers of the window layer with different composition and thickness are provided.

FIG. 2B is a highly simplified cross sectional view of the structure of FIG. 2A after the next process steps according to the present disclosure.

A photoresist mask (not shown) is placed over the cap layer 105 to form the grid lines 106. The grid lines 106 are deposited via evaporation and lithographically patterned and deposited over the cap layer 105. The mask is then subsequently lifted off to form the finished metal grid lines 106 as depicted in the Figures.

As mentioned before the grid lines 106 are preferably composed of Pd/Ge/Ti/Pd/Au, although other suitable materials may be used as well.

In the next process step, the grid lines 106 are used as a mask to etch down the surface to the window layer 104 using a citric acid/peroxide etching mixture or other suitable etchant.

FIG. 2C is a highly simplified cross sectional view of the structure of FIG. 2B after oxidation of the second window layer 104, which is depicted in FIG. 2C as an expanded layer 107, 108 which is thicker than the original second window layer 104. In one embodiment, only the top portion 109 of the second window layer 104 is oxidized, with a small lower portion 107 being unoxidized.

FIG. 2D is a highly simplified cross sectional view of the structure of FIG. 2C after deposition of the first 110 and second 111 ARC layers according to the present disclosure. In one embodiment, layer 110 has a lower band gap than the window layer.

U.S. Patent 9,356,162 of Pan et al has been noted above, and in the discussion of the features of the present disclosure the distinctions of the present disclosure over Pan et al should be noted. More specifically, the Pan patent teaches a thermal oxidation process such as wet oxidation to form the oxidized window layer (column 5, lines 29-30). A separate oxidation furnace (column 5, lines 61-62) is utilized, distinct from the reactor used for the growth of epitaxial layers on the substrate (column 4, lines 50-52). A "standard" solar cell device with the window layer takes place subsequent to the etching of a cap layer (column 7, lines 39-41, and Figure 5 steps 503, 505).

The present disclosure provides a substantially different window structure with several embodiments of alternative process steps that are distinct and unanticipated by Pan et al. First, most notably, in some embodiments Applicant's window layer is less than 250 Angstrom (i.e. 25 um) thick, which is ten times less than that of Pan et al. Although Pan's thick window layer may achieve his objective of effectively minimizing surface recombination of holes and electrons at the top surface of the emitter of the top solar subcell, Applicant's substantially thinner window has been found by Applicant not only to be satisfactory, but in fact superior from a fabrication simplicity and performance perspective, as will be demonstrated from Applicant's quantum efficiency diagram. Applicant has also proposed a number of different embodiments of processes for oxidizing the window layer that are distinct and unanticipated by Pan et al and which will be described in greater detail below.

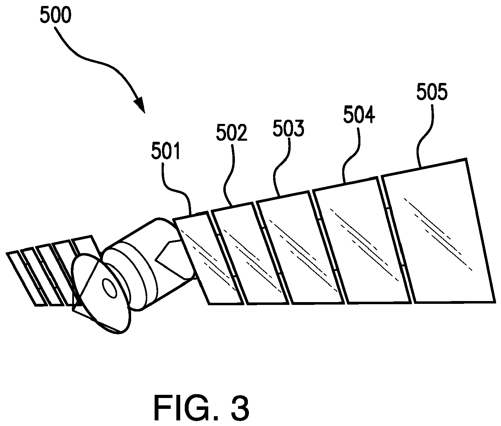

FIG. 3 is a highly simplified perspective view of a first embodiment of a space vehicle incorporating a photoelectric power system according to the present disclosure. The space vehicle 500 includes a plurality of foldable substantially rectangular panels 501, 502, 503, 504, etc. which extend from the vehicle to form "wings".

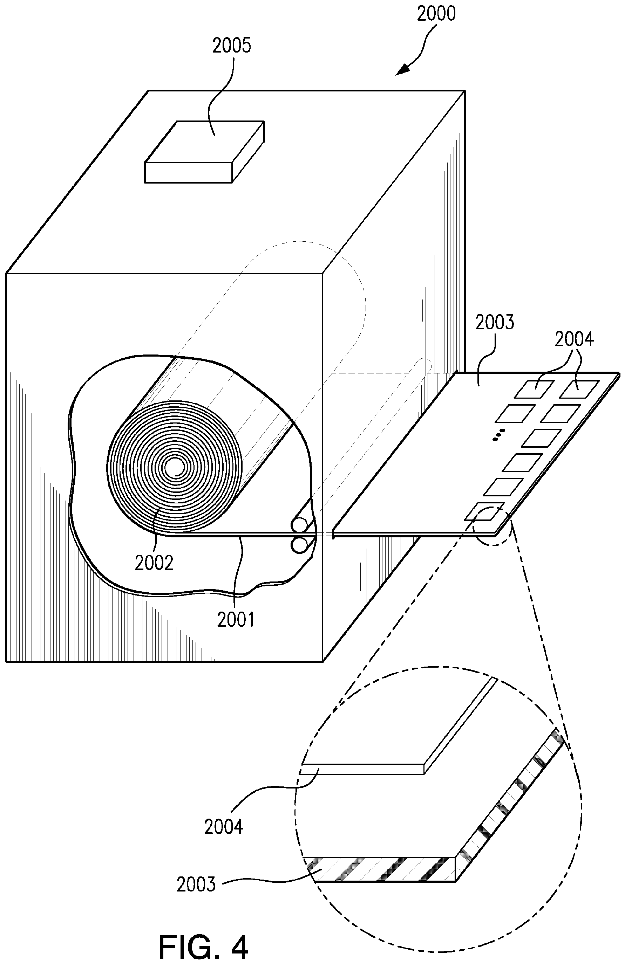

FIG. 4 is a highly simplified perspective view of a second embodiment of a space vehicle incorporating a photoelectric power system with roll-out deployment according to the present disclosure. In this embodiment, the space vehicle 2000 incorporates a solar cell array 2004 mounted on a deployable flexible sheet 2003 in which the solar cell array 2004 incorporates the solar cells or solar cell modules according to the present disclosure.

The sheet 2003 may wrap around a mandrel 2002 prior to being deployed in space. The space vehicle 2000 includes a payload 2005 which is powered by the array of solar cell assemblies 2004.

It will be understood that each of the elements described above, or two or more together, also may find a useful application in other types of structures or constructions differing from the types of structures or constructions described above.

The composition of the various layers in the solar cell may utilize other semiconductor compounds, subject to lattice constant and band gap requirements, and may include AlInP, AlAs, AIP, AlGaInP, AIGaAsP, AlGaInAs, AlGaInPAs, GalnP, GaInAs, GaInPAs, AIGaAs, AlInAs, AlInPAs, GaAsSb, AlAsSb, GaAlAsSb, AlInSb, GaInSb, AlGaInSb, AIN, GaN, InN, GalnN, AlGaInN, GaInNAs, AlGaInNAs, ZnSSe, CdSSe, and similar materials, and still fall within the spirit of the present invention.

Without further analysis, from the foregoing others can, by applying current knowledge, readily adapt the present invention for various applications. Such adaptations should and are intended to be comprehended within the meaning and range of equivalence of the following claims.

## Claims

1. A multijunction solar cell comprising:
a top solar subcell having an emitter layer and a base layer forming a photovoltaic junction and a window layer disposed over the emitter layer, the window layer being composed of a material having a band gap of greater than 2.6 eV and a thickness of less than 100 nm.

2. A multijunction solar cell as defined in claim 1, wherein the emitter of the top solar subcell is composed of InAIGaP with the aluminum content in a range of 10 to 40% by mole fraction.

3. A multijunction solar cell as defined in any of the preceding claims, wherein the window layer is composed of InAIP, or AIGaAs or Al InGaAs with a band gap of greater than 4 eV and wherein the window layer is oxidized throughout its entire thickness.

4. A multijunction solar cell as defined in claim 1 or 2 wherein the window layer is composed of zinc selenide and is disposed directly adjacent to the emitter layer of the top solar subcell.

5. A multijunction solar cell as defined in any of the preceding claims, further comprising an oxidation stop layer disposed between the emitter layer of the top solar subcell and the window layer of the top solar subcell, the oxidation stop layer being composed of InAIP with the Al content of oxidation stop layer in the range of 50 to 75% by mole fraction.

6. A multijunction solar cell as defined in any of the preceding claims, further comprising (*i*) passivation layer disposed over the emitter layer of the top solar subcell, with the window layer being disposed directly over the passivation layer; and (*ii*)a cap layer disposed over the window layer, with portions of the top surface of the cap layer being subsequently etched down to the surface of the window layer.

7. A multijunction solar cell as defined in claim 6, further composing on antireflection structure including at least four layers with a sequence of layers with successive low band gap and high band gap layers disposed over the window layer, wherein a low band gap layer is a layer with a band gap of less than 3.5 eV, and a high band gap layer is a layer with a band gap of greater than 6 eV.

8. A multijunction solar cell as defined in in any of the preceding claims, further comprising a multilayers antireflection structure that includes a low band gap TiO₂ layer and a high band gap Al₂O₃ layer adjacent thereto disposed over the window layer.

9. A multijunction solar cell as defined in any preceding claims, wherein the window layer is composed of InAlP or InGaP and the Al content at the bottom surface of the window layer is 48.5% by mole fraction or less.

10. A multijunction solar cell as defined in any of the preceding claims, wherein the base of the top solar subcell is composed of InGaP and the emitter of the top solar subcell is composed of InGaP, and the base of the top solar subcell has a band gap that is equal to or greater than 1.83 eV.

11. A multijunction solar cell as defined in any of the preceding claims, wherein the emitter of the top solar subcell has a thickness of 80 nm, and the window layer disposed above the top solar subcell has a thickness of less than 220 Angstroms.

12. A method of manufacturing a solar cell, optionally a solar cell according to any of claims 1 - 11, comprising:
forming a sequence of solar subcells with different band gaps on a substrate;
the top solar subcell of the sequence of solar subcells having an emitter layer and a base layer forming a photovoltaic junction; depositing a window layer with a thickness of less than 30 nm over the emitter layer on the top solar subcell; and
oxidizing at least a portion of the window layer.

13. A method according to claim 12, wherein the multijunction solar cell is fabricated in an MOCVD reactor, and the material of the window layer is oxidized in a separate reaction apparatus by a wet or dry oxidation process.

14. A method according to claim 12, wherein the multijunction solar cell is fabricated in an MOCVD reactor, and wherein the oxidation process of the window layer within the MOCVD reactor is a wet oxidation process.

15. A method according to any of claims 12 - 14, wherein the solar cell comprises a cap layer disposed over the window layer, wherein the method comprises etching down portions of the top surface of the cap layer to the surface of the window layer, and portions of the window layer being exposed following etching of portions of the cap layer are subsequently subjected to an oxidation process.
